# EUROPÄISCHE PATENTSCHRIFT

(11) **EP 2 058 873 B1**
(45) Veröffentlichungstag und Bekanntmachung des Hinweises auf die Patenterteilung: **16.04.2014**
(21) Anmeldenummer: 08105406.6
(22) Anmeldetag: 23.09.2008
(51) Int. Cl.: H01L 41/053

(54) **Piezoaktor und Piezoaktormodul mit einem Schutzschichtsystem**
Piezo actuator and piezo actuator module with a protective coating system
Piézoactionneur et module de piézoactionneur doté d'un système de couche de protection

(30) Priorität: 08.11.2007 DE 102007053303
(43) Veröffentlichungstag der Anmeldung: 13.05.2009
(73) Patentinhaber: ROBERT BOSCH GMBH, 70442 Stuttgart (DE)
(72) Erfinder: Cromme, Peter, 96050, Bamberg (DE); Klotz, Claudia, 96047, Bamberg (DE); Sommariva, Helmut, 8053, Graz (AT); Landvogt, Robert, 96231, Staffelstein (DE)

(56) Entgegenhaltungen:
- EP-A1- 0 977 285
- DE-A1- 19 948 359

## Beschreibung

### Stand der Technik

Die Erfindung betrifft einen Piezoaktor und ein Piezoaktormodul mit einer vorzugsweise metallenen äußeren Schutzschicht eines Schutzschichtsystems gemäß der Gattung des Anspruchs 1, die beispielsweise in einem Piezoinjektor zur zeitpunkt- und mengengenauen Dosierung von Kraftstoff in einem Verbrennungsmotor eingesetzt werden können.

Ein solcher Piezoinjektor besteht im wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

In Diesel-Piezoinjektoren werden bei der so genannten direkten Düsennadelsteuerung die Piezoaktoren direkt im Dieselkraftstoff unter Hochdruck betrieben. Zum Schutz der Piezoelemente, beispielsweise im Hinblick auf deren elektrische Isolation, ist es bekannt, den Piezoaktor mit einem dieselfesten Elastomer zu umhüllen. Nachteilig hieran ist, dass hierfür verwendete Elastomere nicht diffusionsfest gegenüber Dieselkraftstoff, Wasser sowie sonstigen Medien im Kraftstoff sind.

Beispielsweise ist aus der WO 2001 48834A ein solcher Piezoaktor bekannt, bei dem die elektrische Isolation des Piezoaktors durch einen Schutzmantel aus Kunststoff, der beispielsweise durch Spritzgießen aufgebracht wird, vorgenommen wird. Ferner ist für sich gesehen beispielsweise aus der DE 101 39 871 A1 bekannt, dass der Piezoaktor gegen das umgebende Medium durch eine stabile Metallhülse geschützt bzw. gekapselt wird und mit Anbindeteilen am Aktorkopf und am Aktorfuß fest verbunden wird, zum Beispiel durch Schweißen. Aus EP977285 und DE19948359 sind Aktoren mit inneren und äußeren Gehäuseteilen bekannt.

### Offenbarung der Erfindung

Die Erfindung geht von einem eingangs beschriebenen Piezoaktormodul mit einem Piezoaktor aus, der zwischen Anbindeteile angeordnete Piezoelemente aufweist, mit einem mindestens die Piezoelemente umschließenden Schutzschichtsystem aus einer inneren isolierenden ersten Schicht, einem sogenannten Basecoat auf der Basis eines Kunststoffes besteht und einer darüberliegenden metallischen zweiten Schicht. Erfindungsgemäß besteht in vorteilhafter Weise die zweite Schicht als sogenanntes Topcoat aus mindestens zwei Lagen, die derart übereinanderliegen, dass die zu den Anbindeteilen hinweisenden seitlichen Bereiche einer Lage einen vorgegebenen Betrag über die jeweils andere Lage hinausragen, wobei nach der Umhüllung des Piezoaktors die hervorstehenden seitlichen Bereiche mit dem jeweiligen Anbindeteil dicht verbunden sind.

Die zweite Schicht kann dabei aus mindestens zwei Metallhülsen bestehen, die verschränkt zueinander aufgebracht sind oder auch aus mindestens zwei in der Regel dünnen Metallfolien bestehen, die verschränkt zueinander aufgewickelt oder aufgebracht sind, wobei die seitliche Bereiche einer Metallfolie die jeweils andere Metallfolie überragen. Bei der Verwendung von Metallfolien kann auch in vorteilhafter Weise die erste Schicht aus einem den Piezoaktor umschließenden Gel und einem darüberliegenden Formschlauch bestehen. Die erste Schicht enthält vorzugsweise ein Perfluorether-Gel und bei der Verwendung eines Formschlauchs kann dieser ein PTFE-Formschlauch (PTFE= Polytetrafluorethylen) sein.

Die Anbindeteile sind dabei vorzugsweise ein Aktorkopf und/oder ein Aktorfuß, über die das Piezoaktormodul in einer weiteren Anordnung gehalten ist, wobei in vorteilhafter Weise das Piezoaktormodul bzw. der Piezoaktor Bestandteil eines Piezoinjektors für ein Einspritzsystem für Kraftstoff bei einem Verbrennungsmotor ist, wobei der Kraftstoff das Schutzschichtsystem umströmt.

Das vorgeschlagene metallische Schutzschichtsystem für den Piezoaktor ist besonders dadurch vorteilhaft, dass die Bewegung des Piezoaktors nicht gehindert wird und der Piezoaktor vor dem Kraftstoff wirkungsvoll geschützt ist. Das Topcoat des metallischen Schutzschichtsystems mit den mindestens zwei dünnen Metallfolien oder -Hülsen und kann auf einfache Weise durch ein stoff- und/oder formschlüssiges Verbindungsverfahren an dem Piezoaktor befestigt werden.

Damit eine ausreichende dynamische Dehnung des fest an die metallischen Anbindeteile des Piezoaktormoduls angebundenen metallischen Schutzsystems gewährleistet ist, werden somit erfindungsgemäß die mindestens zwei Metallfolien oder -hülsen so aufgebracht, dass jeweils alternierend eine Metallfolie oder -Hülse entweder am Aktorkopf oder am Aktorfuß oder an beliebigen Anbindeteilen des Piezoaktormoduls befestigt ist. Die Metallfolien sind somit verschränkt zueinander aufgewickelt oder aufgebracht.

Die Metallhülsen oder Metallfolien können dabei untereinander auf einfache Weise mit einem zum Beispiel dieselbeständigen, elektrisch isolierenden Elastomer verklebt werden, sodass sich durch diese ineinander verschränkt bzw. kammartig aufgebrachten metallischen Folien oder - Hülsen lange Diffusionswege für den Dieselkraftstoff ergeben und somit bei einem evtl. Eindringen des Dieselkraftstoffes in das metallische Schutzschichtsystem viel Zeit vergeht bis der Dieselkraftstoff die eigentlichen piezoelektrischen Schichten erreicht.

### Kurze Beschreibung der Zeichnungen

Die Erfindung wird nachfolgend anhand der Zeichnungen erläutert. Dabei zeigen:
- Figur 1: eine schematische Darstellung eines Piezoaktors mit zwei verschränkt aufzubringenden Metallfolien als Schutzschichtsystem,
- Figur 2: einen Schnitt durch ein erfindungsgemäßes Piezoaktormodul mit einem Schutzschichtsystem und
- Figur 3: einen Schnitt durch ein erfindungsgemäßes Piezoaktormodul mit einem Schutzschichtsystem und mit einem Aktorkopf und einem Aktorfuß als Anbindeteile,
- Figur 4: einen Querschnitt durch einen Piezoaktor mit Metallhülsen als zweite Schicht (Topcoat) und
- Figur 5: einen Querschnitt durch einen Piezoaktor mit Metallfolien als zweite Schicht (Topcoat) auf einem Formschlauch.

### Ausführungsformen der Erfindung

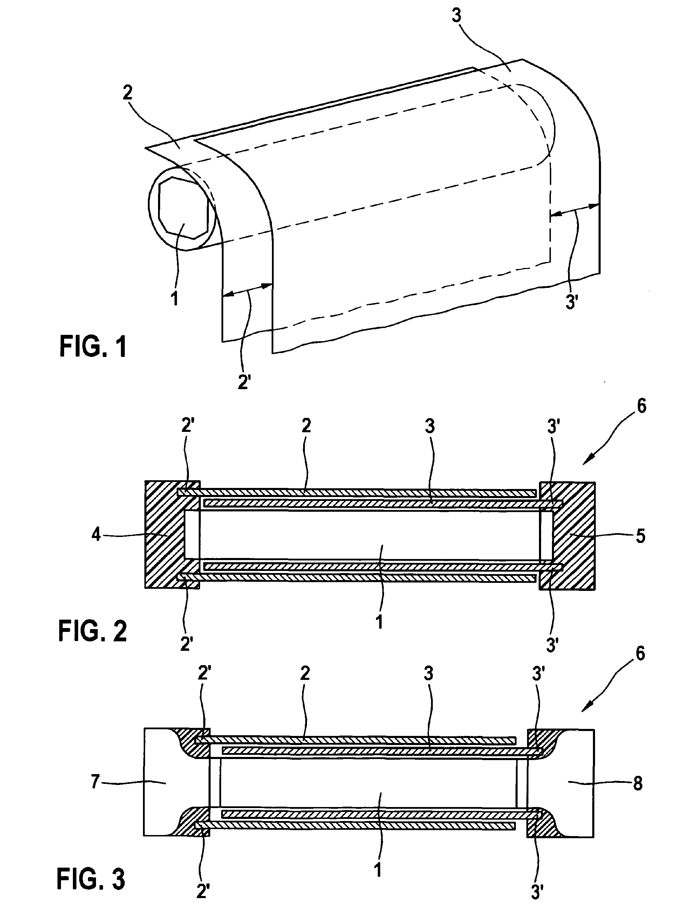

Ein in Figur 1 zur Erläuterung des erfindungemäßen Piezoaktormoduls dargestellter Piezoaktor 1 wird als vorteilhaftes Ausführungsbeispiel mit einem Schutzschichtsystem aus Metallfolien 2 und 3 als Topcoat versehen. Ein solches Piezoaktormodul ist aus dem in der Beschreibungseinleitung gewürdigten Stand der Technik bereits bekannt und kann beispielsweise, wie dort beschrieben, zur Nadelhubsteuerung in einem Einspritzsystem für Kraftstoff bei einem Verbrennungsmotor eingesetzt werden.

Die zwei Metallfolien 2 und 3 sind dabei so aufgebracht, dass jeweils alternierend die Metallfolie 2 mit einem Bereich 2' und die Metallfolie 3 mit einem Bereich 3' seitlich herausragt. Die Metallfolien 2 und 3 werden somit verschränkt zueinander aufgewickelt oder aufgebracht.

Aus Figur 2 ist im Schnitt erkennbar, wie die Bereiche 2' und 3' in Anbindeteile 4 und 5 eines Piezoaktormoduls 6 hereinreichen und dort dicht mit diesen Anbindeteilen 4 und 5 jeweils alternierend verbunden werden können. Ein entsprechender Aufbau ist auch mit Metallhülsen erreichbar.

In Figur 3 ist ein Ausführungsbeispiel mit einem Aktorkopf 7 und einem Aktorfuß 8 als Anbindeteile bei einem Piezoaktormodul 6 gezeigt, bei dem die verschränkte Verbindung in gleicher Weise erfolgt wie beim Ausführungsbeispiel nach der Figur 2. Die Metallfolien 2 und 3 können dabei untereinander auf einfache Weise mit einem zum Beispiel dieselbeständigen, elektrisch isolierenden Elastomer verklebt werden, so dass die zuvor erwähnten Vorteile zur Verhinderung des Eindringens von Dieselkraftstoff in das metallische Schutzschichtsystem aus den Metallfolien 2 und 3 erreicht werden.

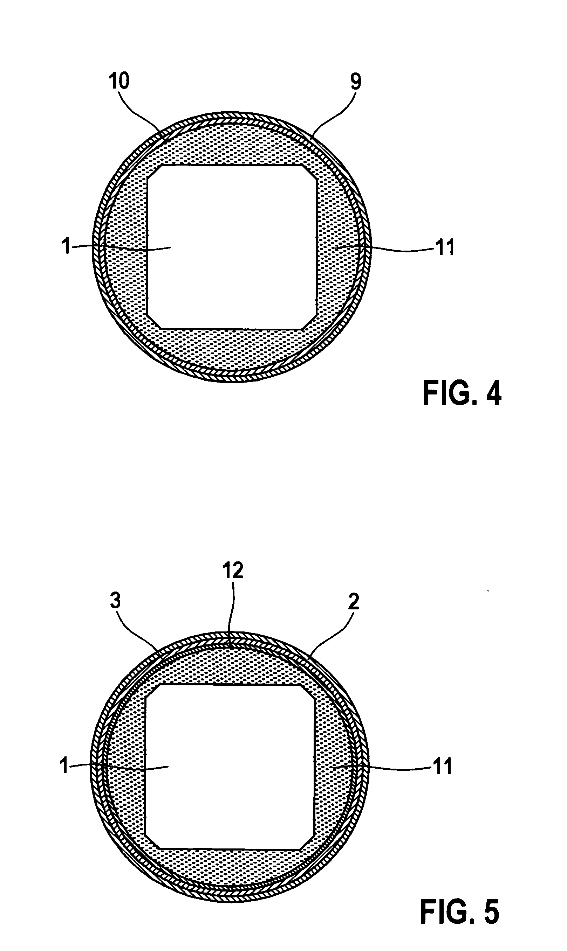

Aus einer Darstellung nach Figur 4 ist im Querschnitt der Piezoaktor 1 mit Metallhülsen 9 und 10 als zweite Schicht (Topcoat) erkennbar, wobei als erste isolierende Schicht 11 (Basecoat) hier ein Perfluorether-Gel vorhanden ist, das den Piezoaktor 1 umhüllt. Figur 5 zeigt noch eine Alternative mit einem außen auf der ersten Schicht 11 (Basecoat), zum Beispiel Perfluorether-Gel, aufgebrachten Formschlauch 12, auf dem dann hier die Metallfolien 2 und 3 nach den Figuren 1 bis 3 liegen.

## Patentansprüche

1. Piezoaktormodul mit einem Piezoaktor (1), der zwischen Anbindeteile (4,5) angeordnete Piezoelemente aufweist, mit einem mindestens die Piezoelemente umschließenden Schutzschichtsystem aus einer inneren isolierenden ersten Schicht (11) und einer darüberliegenden metallischen zweiten Schicht, **dadurch gekennzeichnet, dass** die zweite Schicht aus mindestens zwei Lagen (2,3;9,10) besteht, die derart übereinanderliegen, dass die zu den Anbindeteilen (4,5) hinweisenden seitlichen Bereiche (2',3') einer Lage einen vorgegebenen Betrag über die jeweils andere Lage (2,3;9,10) hinausragen und die nach der Umhüllung des Piezoaktors (1) hervorstehenden seitlichen Bereichen (2',3') mit dem jeweiligen Anbindeteil (4,5) dicht verbunden sind.

2. Piezoaktormodul nach Anspruch 1, **dadurch gekennzeichnet, dass** die zweite Schicht aus mindestens zwei Metallhülsen (9,10) besteht, die verschränkt zueinander aufgebracht sind.

3. Piezoaktormodul nach Anspruch 1, **dadurch gekennzeichnet, dass** die zweite Schicht aus mindestens zwei Metallfolien (2,3) besteht, die verschränkt zueinander aufgewickelt oder aufgebracht sind, wobei die seitlichen Bereiche (2',3') einer Metallfolie (2,3) die jeweils andere Metallfolie (2,3) überragen.

4. Piezoaktormodul nach Anspruch 3, **dadurch gekennzeichnet, dass** die erste Schicht (11) aus einem den Piezoaktor (1) umschließenden Gel und einem darüberliegenden Formschlauch (12) besteht.

5. Piezoaktormodul nach Anspruch 4, **dadurch gekennzeichnet, dass** der Formschlauch (12) ein PTFE-Formschlauch ist.

6. Piezoaktormodul nach einem der vorhergehenden Ansprüche, **dadurch gekennzeichnet, dass** die erste Schicht (11) ein Perfluorether-Gel enthält.

7. Piezoaktormodul nach einem der vorhergehenden Ansprüche, **dadurch gekennzeichnet, dass** die Anbindeteile ein Aktorkopf (7) und/oder ein Aktorfuß (8) sind.

8. Piezoaktormodul nach einem der vorhergehenden Ansprüche, **dadurch gekennzeichnet, dass** die Metallfolien (2,3) oder die Metallhülsen (9,10) untereinander mittels einer Elastomerschicht verbunden sind.

9. Piezoaktormodul oder Piezoaktor nach einem der vorhergehenden Ansprüche, **dadurch gekennzeichnet, dass** das Piezoaktormodul (6) oder der Piezoaktor (1) Bestandteil eines Piezoinjektors für ein Einspritzsystem für Kraftstoff bei einem Verbrennungsmotor ist, wobei der Kraftstoff das Schutzschichtsystem umströmt.

## Claims

1. Piezo actuator module with a piezo actuator (1), which has piezo elements arranged between linking parts (4, 5), with a protective layer system enclosing at least the piezo elements and consisting of an inner insulating first layer (11) and a metallic second layer lying thereover, **characterized in that** the second layer consists of at least two plies (2, 3; 9, 10), which lie one on top of the other in such a way that the lateral regions (2', 3') of one ply, facing the linking parts (4, 5), protrude by a predetermined amount beyond the other ply (2, 3; 9, 10) respectively, and the lateral regions (2', 3') that protrude after the enclosing of the piezo actuator (1) are connected to the respective linking part (4, 5) in a sealing manner.

2. Piezo actuator module according to Claim 1, **characterized in that** the second layer consists of at least two metal sleeves (9, 10), which are applied overlapping one another.

3. Piezo actuator module according to Claim 1, **characterized in that** the second layer consists of at least two metal foils (2, 3), which are wound on or applied overlapping one another, the lateral regions (2', 3') of one metal foil (2, 3) protruding beyond the other metal foil (2, 3) respectively.

4. Piezo actuator module according to Claim 3, **characterized in that** the first layer (11) consists of a gel enclosing the piezo actuator (1) and a moulded tube (12) lying thereover.

5. Piezo actuator module according to Claim 4, **characterized in that** the moulded tube (12) is a PTFE moulded tube.

6. Piezo actuator module according to one of the preceding claims, **characterized in that** the first layer (11) contains a perfluoroether gel.

7. Piezo actuator module according to one of the preceding claims, **characterized in that** the linking parts are an actuator head (7) and/or an actuator foot (8).

8. Piezo actuator module according to one of the preceding claims, **characterized in that** the metal foils (2, 3) or the metal sleeves (9, 10) are connected to one another by means of an elastomer layer.

9. Piezo actuator module or piezo actuator according to one of the preceding claims, **characterized in that** the piezo actuator module (6) or the piezo actuator (1) is a component part of a piezo injector for an injection system for fuel in an internal combustion engine, the fuel flowing around the protective layer system.

## Revendications

1. Module de piézoactionneur comprenant un piézoactionneur (1) qui présente des éléments piézoélectriques disposés entre des parties de liaison (4, 5), comprenant un système de couche de protection entourant au moins les éléments piézoélectriques, constitué d'une première couche interne isolante (11) et d'une deuxième couche métallique disposée par-dessus, **caractérisé en ce que** la deuxième couche se compose d'au moins deux strates (2, 3 ; 9, 10) superposées de telle sorte que les régions (2', 3') latérales tournées vers les parties de liaison (4, 5) d'une strate fassent saillie sur une distance prédéfinie au-delà de l'autre strate respective (2, 3 ; 9, 10) et que les régions latérales (2', 3') faisant saillie après l'enveloppement du piézoactionneur (1) soient connectées hermétiquement à la partie de liaison respective (4, 5).

2. Module de piézoactionneur selon la revendication 1, **caractérisé en ce que** la deuxième couche se compose d'au moins deux douilles métalliques (9, 10) qui sont appliquées de manière imbriquée l'une par rapport à l'autre.

3. Module de piézoactionneur selon la revendication 1, **caractérisé en ce que** la deuxième couche se compose d'au moins deux feuilles métalliques (2, 3) qui sont enroulées ou appliquées l'une par rapport à l'autre de manière imbriquée, les régions latérales (2', 3') d'une feuille métallique (2, 3) dépassant de l'autre feuille métallique respective (2, 3).

4. Module de piézoactionneur selon la revendication 3, **caractérisé en ce que** la première couche (11) se compose d'un gel entourant le piézoactionneur (1) et d'un tuyau moulé (12) disposé par-dessus.

5. Module de piézoactionneur selon la revendication 4, **caractérisé en ce que** le tuyau moulé (12) est un tuyau moulé en PTFE.

6. Module de piézoactionneur selon l'une quelconque des revendications précédentes, **caractérisé en ce que** la première couche (11) contient un gel de perfluoro-éther.

7. Module de piézoactionneur selon l'une quelconque des revendications précédentes, **caractérisé en ce que** les parties de liaison sont une tête d'actionneur (7) et/ou une base d'actionneur (8).

8. Module de piézoactionneur selon l'une quelconque des revendications précédentes, **caractérisé en ce que** les feuilles métalliques (2, 3) ou les douilles métalliques (9, 10) sont connectées les unes aux autres au moyen d'une couche élastomère.

9. Module de piézoactionneur ou piézoactionneur selon l'une quelconque des revendications précédentes, **caractérisé en ce que** le module de piézoactionneur (6) ou le piézoactionneur (1) fait partie d'un injecteur piézoélectrique pour un système d'injection de carburant dans un moteur à combustion interne, le carburant circulant autour du système de couche de protection.
